# EUROPEAN PATENT SPECIFICATION

(11) **EP 4 508 358 B1**
(45) Date of publication and mention of the grant of the patent: **04.03.2026**
(21) Application number: 23719447.7
(22) Date of filing: 11.04.2023
(51) Int. Cl.: F16M 13/02, F21V 21/04

(54) **A FITTING FOR MOUNTING A BUILDING CONTROL SENSOR**
ARMATUR ZUR MONTAGE EINES GEBÄUDESTEUERUNGSSENSORS
SUPPORT POUR LE MONTAGE D'UN CAPTEUR DE GESTION DOMOTIQUE

(30) Priority: 12.04.2022 GB 202205361
(43) Date of publication of application: 19.02.2025
(60) Divisional application: 26153459.8
(73) Proprietor: Cucumber Lighting Controls Limited, Coventry West Midlands CV1 2TL (GB)
(72) Inventor: MANS, Paul, Coventry, West Midlands CV1 2TL (GB)
(74) Representative: HGF
(86) International application number: PCT/GB2023/050952
(87) International publication number: WO 2023/199035

(56) References cited:
- EP-A1- 2 675 185
- WO-A1-2018/041610
- GB-A- 2 559 891

## Description

### TECHNICAL FIELD

The present invention relates to a fitting for mounting a building control sensor to a surface. The present invention also relates to a shield attachment for a building control sensor.

### BACKGROUND

Fittings for building control sensors, for example lighting control sensors or fire alarms, can be either surface-mounted fittings or hole-mounted fittings. Surface-mounted fittings have holes for screwing the surface-mounted fitting to a surface. Hole-mounted fittings have some kind of retaining clip, usually a spring retaining clip. WO 2018/041610A1 describes an installation device for mounting in an opening of a building ceiling, with a housing portion which can be pushed into the opening, and a second, flange-like housing portion which is arranged outside the opening, and with spring-loaded expansion arms which hold the device in the ceiling.

Some building control sensors (for example motion detectors) have a lens that defines a field of view of the sensor. The field of view of such sensors often needs to be changed or adjusted on installation, for example to only cover a particular area such as a corridor. The field of view can be changed by covering a part of the lens with a sticky label or a shield which is cut to the required size.

It is an aim of certain examples of the present invention to solve, mitigate or obviate, at least partly, at least one of the problems and/or disadvantages associated with the prior art.

### SUMMARY OF THE INVENTION

According to a first aspect of the present invention there is provided a fitting for mounting a building control sensor to a surface, according to claim 1.

Accordingly, the fitting can be configured for surface-mounting (using the mounting holes) or for hole-mounting (using the spring retaining clips). Advantageously this can reduce the number of different parts that need to be manufactured, and the fitting can be adapted for the specific installation at the installation site.

According to claim 1, the spring retaining clip is removeable. In examples, the spring retaining clip is at least partly aligned with the mounting hole. The spring retaining clip may prevent use of the mounting hole until the spring retaining clip is removed.

The spring retaining clip is mounted in a recess of the fitting. According to claim 1, the mounting hole may extend from the recess.

In examples, the fitting comprises a mounting surface arranged to abut the surface when using the mounting hole. The mounting hole may be perpendicular to the mounting surface. The mounting surface may be planar.

In examples, the fitting may comprise first and second mounting holes, and first and second spring retaining clips. The first and second mounting holes may be disposed on opposing sides of the fitting. Similarly, the first and second spring retaining clips may be disposed on opposing sides of the fitting. In examples, the fitting may comprise more than two mounting holes and/or more than two spring retaining clips.

In examples, the fitting may further comprise a power supply unit. The power supply unit may be housed within a recess formed in the fitting. The power supply unit may comprise one or more terminals for attachment to an external power source. The power supply unit may additionally comprise one or more terminals for external control cables, for example of a building control network. The fitting may include a cable clamp for clamping cables to the fitting. The fitting may include a removable cover for covering the power supply unit. The removable cover may act as a part of the cable clamp.

In examples, the fitting may further comprise a clip for attaching the building control sensor to the fitting. The clip may removably attach the building control sensor to the fitting. In examples, the clip comprises a resiliently deflectable prong protruding from the fitting and arranged to engage a clip hole of the building control sensor.

In examples, the fitting may further comprise a connector arranged to provide an electrical connection between the fitting, in particular the power supply unit, and the building control sensor when the building control sensor is attached to the fitting.

In examples, the fitting comprises a first housing portion and a second housing portion. In examples, the power supply unit is disposed in a recess formed between the first and second housing portions. In examples, the first housing portion is positionable against the surface when the fitting is surface mounted, and the building control sensor is attachable to the second housing portion.

According to a second aspect of the present invention, there is also provided a building control sensor system comprising of the fitting described above and a building control sensor attachable to the fitting.

In examples, the building control sensor system further comprises a sleeve for surrounding the fitting when the fitting is attached to the surface via the one or more mounting holes. In examples, the building control sensor comprises a flange. The sleeve may be positionable between the surface and the flange during use.

In examples, the building control sensor is a lighting control sensor. For example, the building control sensor may comprise a sensor configured to detect one or more of movement, motion, presence, absence, and/or occupancy. The building control sensor may comprise a passive infrared (PIR) sensor. The building control sensor may comprise a sensor and a lens.

In other examples, the lighting control sensor may be a light level sensor adapted to detect an environment light level. In other examples the lighting control sensor may detect other environment characteristics for controlling lighting.

In other examples, the building control sensor may comprise a fire alarm sensor, for example a smoke or heat detector. In other examples, the building control sensor may comprise a gas sensor, for example a carbon monoxide sensor or sensor for other gases, particularly noxious gases.

In examples, the building control sensor is a lighting control sensor. For example, the building control sensor may comprise a sensor configured to detect one or more of movement, motion, presence, absence, and/or occupancy. The building control sensor may comprise a passive infrared (PIR) sensor.

In other examples, the lighting control sensor may be a light level sensor adapted to detect an environment light level. In other examples the lighting control sensor may detect other environment characteristics for controlling lighting.

In other examples, the building control sensor may comprise a fire alarm sensor, for example a smoke or heat detector. In other examples, the building control sensor may comprise a gas sensor, for example a carbon monoxide sensor or sensor for other gases, particularly noxious gases.

It will be appreciated that different aspects of the present invention may be combined together. For example, a building control sensor system may comprise a fitting for mole-mounting or surface-mounting, as described above, and also a building control sensor with the shield attachment as described above.

### BRIEF DESCRIPTION OF THE DRAWINGS

Examples of the invention are further described hereinafter with reference to the accompanying drawings, in which:
FIGS. 1A and 1B illustrate a building control sensor with a fitting in a hole mounting configuration;
FIGS. 2A and 2B illustrate a building control sensor with a fitting in a surface mounting configuration;
FIG. 3 illustrates the separation of the building control sensor from the fitting;
FIG. 4 illustrates the fitting in isolation;
FIG. 5 illustrates the building control sensor in isolation;
FIG. 6 illustrates features of a power supply unit of the fitting;
FIG. 7 illustrates the mounting features of the fitting;
FIG. 8 illustrates a magnified view of the mounting features of the fitting;
FIG. 9 illustrates a cross-section of the fitting, in particular the mounting features;
FIG. 10 illustrates an exploded view of the fitting;
FIG. 11 illustrates a part of a cover for the fitting;
FIG. 12 illustrates a building control sensor with a shield frame attached thereto;
FIG. 13 illustrates a shield attached to the building control sensor; and
FIG. 14 illustrates the shield frame and shield of FIGS. 13 and 14.

### DETAILED DESCRIPTION

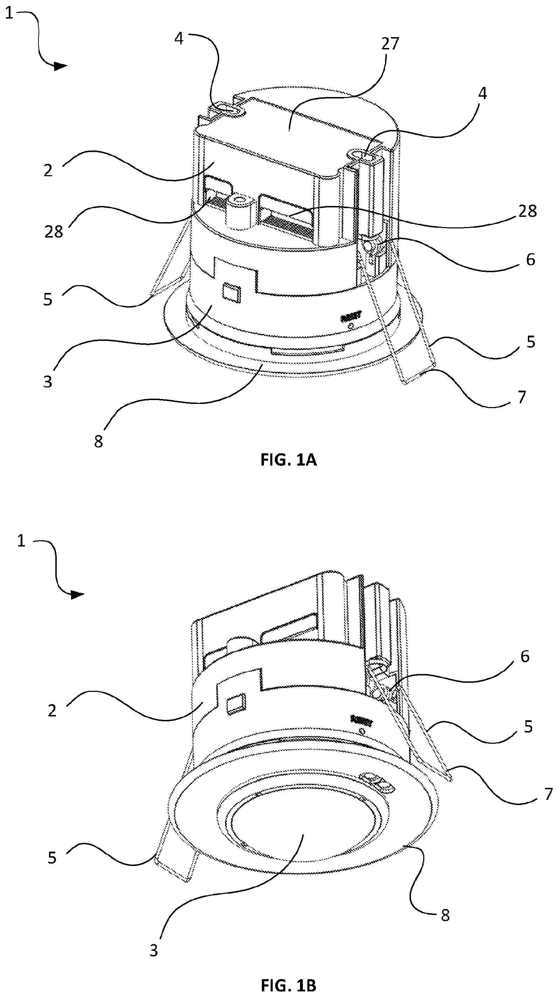

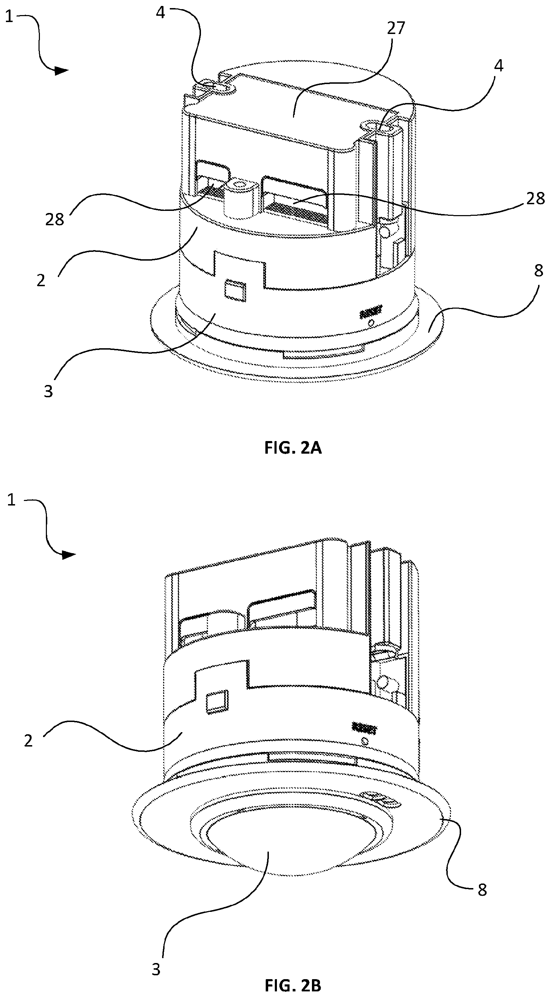

As illustrated in FIGS. 1A to 2B, the present invention relates to a fitting 2 for mounting a building control sensor 3 to a surface. The fitting 2 has a mounting hole 4 for screwing the fitting to a surface in a surface-mounted configuration. The fitting 2 also has a spring retaining clip 5 adapted to retain the fitting 2 within a hole formed in a surface in a hole-mounting configuration. Accordingly, the fitting 2 can be configured for hole-mounting, as shown in FIGS. 1A and 1B, or for surface-mounting, as shown in FIGS. 2A and 2B. FIGS. 1A to 2B illustrate a building control sensor system 1 that includes the fitting 2 and the building control sensor 3.

As shown in FIGS. 1A and 1B, in the hole-mounting configuration there are two spring retaining clips 5 arranged on opposite sides of the fitting 2. The spring retaining clips 5 each comprise a torsion spring portion 6 mounted at the fitting 2, and an arm 7 extending from the torsion spring portion 6. During use, the fitting 2 and a part of the building control sensor 3 extend through a hole formed in the surface. The building control sensor 3 includes a flange 8 that abuts a first side of the surface, and the torsion spring portions 6 bias the arms 7 against the opposite side of the surface so that the spring retaining clips 5 act against the flange 8 to mount the building control sensor system 1 in the hole.

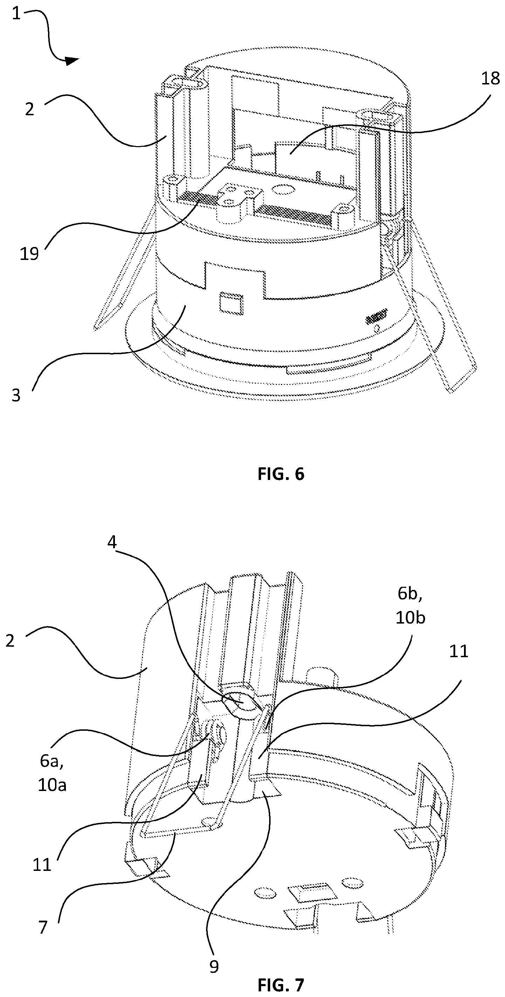

As shown more clearly in FIGS. 7 to 9, the fitting 2 comprises a mounting recess 9 for each spring retaining clip 5. Within the mounting recess 9 two spigots 10a, 10b extend towards each other and each spigot 10a, 10b. The torsion spring portion 6 comprises two parts 6a, 6b that are spaced apart. The arm 7 extends from the part 6a of the torsion spring portion 6, away from the fitting 1, and back to the second part 6b of the torsion spring portion 6. The two spigots 10a, 10b engage, respectively, the first and second parts 6a, 6b of the torsion spring portion 6 of the spring retaining clip 5. In this way, the spring retaining clips 5 are attached to the fitting 2 at the spigots 10a, 10b. A stopper 11 is arranged to engage a free end 12 of the torsion spring portion 6 of each spring retaining clip 5 to restrict rotation of the spring retaining clip 5 and allow the torsion spring portion 6 to bias the arms 7 as described above.

As illustrated, the two spigots 10a, 10b extend from sidewalls 13 of each mounting recess 9. The two spigots 10a, 10b are parallel to each other and spaced apart. Accordingly, the spring retaining clips 5 can be detached from the fitting 2 by deflecting the two parts 6a, 6b of the spring retaining clips 5 towards each other and removing them from the spigots 10a, 10b through the gap between the spigots 10a, 10b. Accordingly, the fitting 2 can be adapted for surface-mounting by removing the spring retaining clips 5.

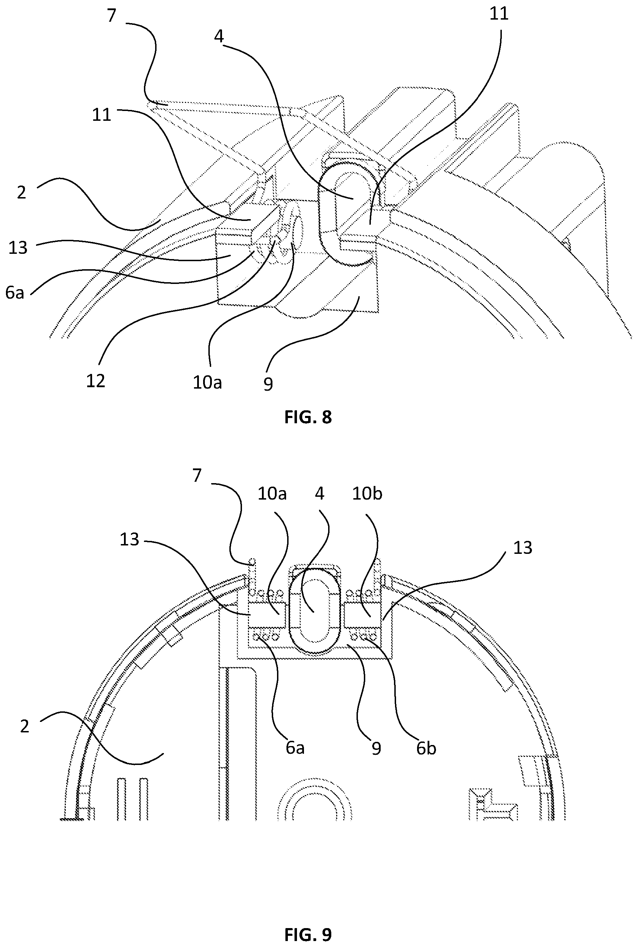

As shown in FIG. 9, the mounting hole 4 is aligned with the spring retaining clip 5. In particular, the mounting hole 4 extends from the mounting recess 9, and the spigots 10a, 10b are arranged proximal to the mounting hole 4 in the mounting recess 9. Accordingly, the mounting holes 4 may be unusable when the spring retaining clips 5 are attached to the fitting 2.

In the configuration illustrated in FIGS. 2A and 2B the spring retaining clips (5, see FIG. 1A) have been removed as described above and the fitting 2 can be used for surface-mounting by the mounting holes 4. The mounting holes 4 extend through a part of the fitting 2 and allow a screw (or bolt or other fastener) to pass through for attaching the fitting 2 to the surface.

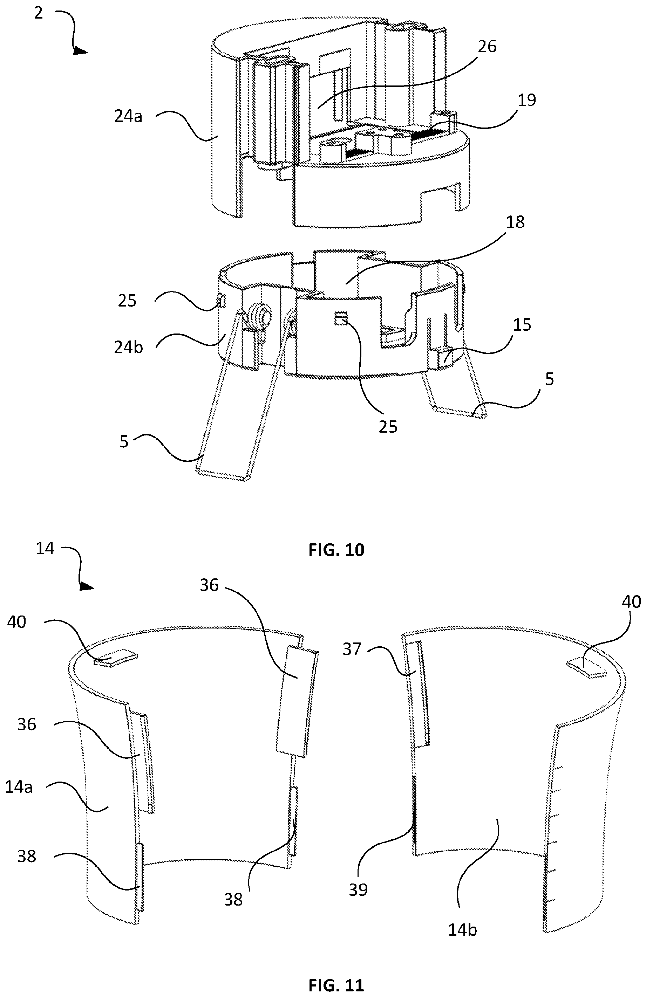

A sleeve 14, such as that illustrated in FIG. 11, may be positioned between the surface and the flange 8 on the building control sensor 3 to cover the fitting 4. The sleeve 14 additionally covers parts of the building control sensor 3 located on the side of the flange 8 facing the fitting 2. The sleeve 14 is used when the fitting 2 is surface-mounted using the mounting holes 4, so that the fitting 2 and parts of the building control sensor 3 are not visible once installed. The sleeve 14 thereby improves the appearance of the building control sensor system 1, and also provides protection for the fitting 2 and electronics housed therein.

As shown in FIG. 11, the sleeve 14 may be formed of two parts 14a, 14b that clip together about the fitting 2. The sleeve 14 has a substantially cylindrical shape when assembled, although it may include a taper or curve to accommodate the fitting 2 and to improve the aesthetics of the sleeve 14.

The first part 14a can have male connector parts 36, and the second part 14b can have female connector parts 37. The male connector parts 36 may be resiliently deformable and configured to clip into the female connector parts 37. The first part 14a may also include alignment ribs 38 that engage with alignment grooves 49 formed in the second part 14b to ensure alignment between the first and second parts 14a, 14b of the sleeve 14.

As shown, one or both of the first and second parts 14a, 14b may also include a retaining member 40 arranged to engage a part of the fitting 2 such that the sleeve 14 is held in place on the fitting 2 even if the building control sensor 3 is removed. This allows the sleeve 14 to be positioned before attaching the building control sensor 3, and also means that the building control sensor 3 can be removed and the sleeve 14 can stay in place. Additionally, providing the sleeve 14 in two parts 14a, 14b that clip together allows the sleeve 14 to be installed (i.e., positioned about the fitting 2) after the fitting 2 has been attached to the surface and after the building control sensor 3 has been attached.

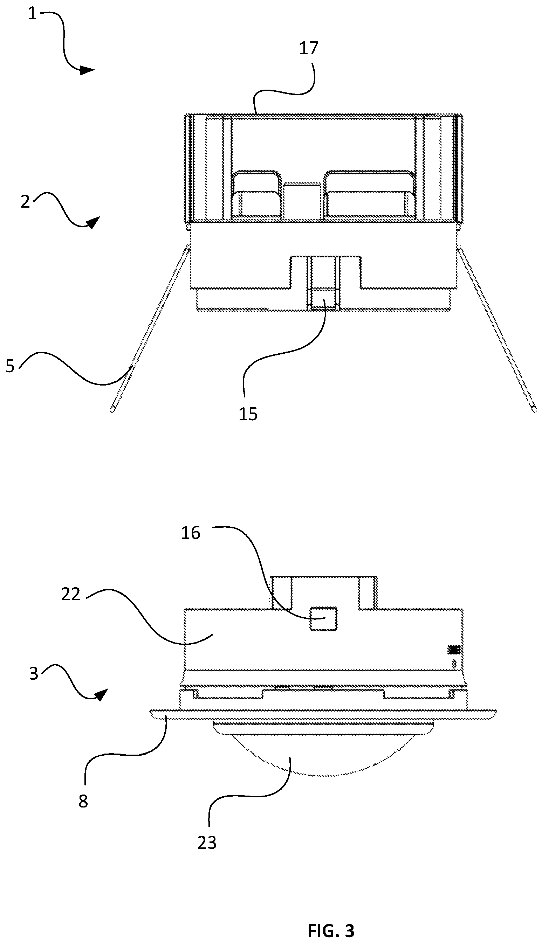

As shown in FIGS. 3 to 5, the building control sensor 3 is detachable from the fitting 2. In particular, the fitting 2 includes the mounting holes (not visible in FIG. 3) and spring retaining clips 5, and two clip members 15 for attaching to the building control sensor 3. The building control sensor 3 includes two clip holes 16 that correspond to the clip members 15 of the fitting 2. The clip members 15 are resiliently deflectable prongs that engage the clip holes 16 to removably secure the building control sensor 3 to the fitting 2.

The fitting 2 has a mounting surface 17 that is placed against the surface in the surface-mounted configuration (FIGS. 2A and 2B), and the building control sensor 3 is attachable to a side of the fitting 2 opposite to the mounting surface 17. In this way the building control sensor 3 is directed into the room (i.e., away from the surface) when mounted.

As most clearly illustrated in FIG. 6, the fitting 2 comprises a power supply unit. In particular, the fitting 2 comprises a recess 18 within which power terminals can be mounted. The fitting 2 also includes a cable clamp 19 for securing one or more cables to the fitting 2, which are then connected to a power supply unit housed in the recess 18. The power supply unit may be connected to power cables in the building. The power supply unit may additionally have one or more control cable connections for connection to a building control network. In this way, the fitting 2 can provide power and control connections between a building power and control network and the building control sensor system 1.

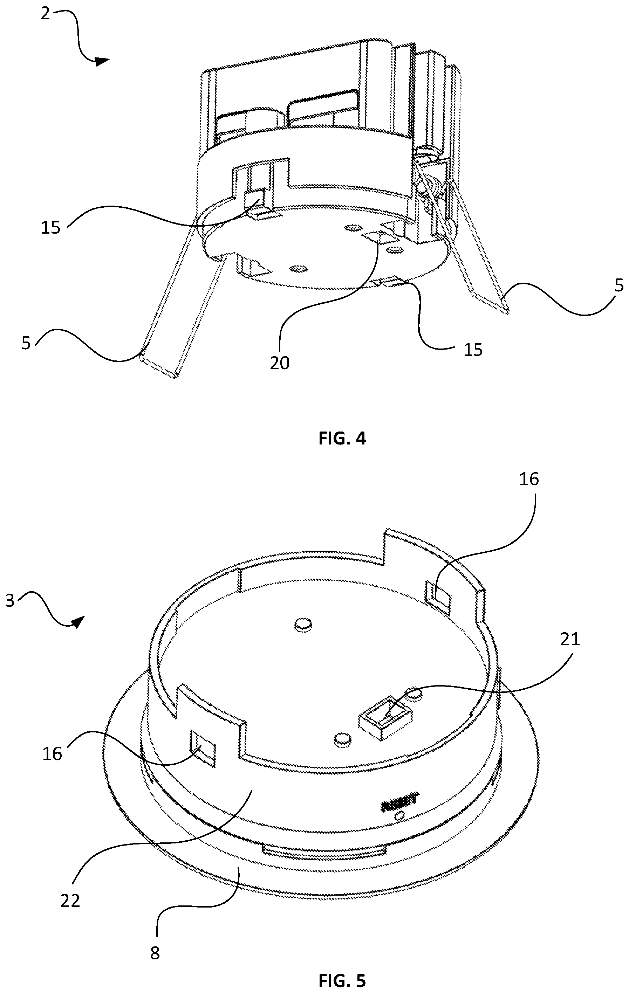

As shown in FIG. 4, the fitting 2 has an electrical connector 20 that faces the building control sensor 3 when the building control sensor 3 is attached to the fitting 2. As shown in FIG. 5, the building control sensor 3 has an electrical connector 21 that corresponds with, and connects to, the electrical connector 20 on the fitting when the building control sensor 3 is attached to the fitting 2. In this way, power and control at the power supply unit in the fitting 2 can be provided to the building control sensor 3.

As shown in FIGS. 3 and 5, the building control sensor 3 includes a housing 22, of which the flange 8 is a part. The building control sensor 3 also includes a lens 23. The lens 23 is partly spherical and protrudes away from the surface to which the fitting 2 is mounted. Within the building control sensor 3 are one or more sensors, and optionally a controller and/or other electronics for operating the sensor(s). The sensor(s) may be movement sensors, motion sensors, presence sensors, absence sensors, occupancy sensors, passive infrared (PIR) sensors, or others.

As shown in FIG. 10, the fitting 2 comprises a first housing part 24a and a second housing part 24b. The first and second housing parts 24a, 24b are attached to each other through clips 25 on the second housing part 24b that engage corresponding recesses (not shown) on the first housing part 24a. The clips 25 permit detachment of the first and second housing parts 24a, 24b. The power supply unit described above may be located in the recess 18 formed between the first and second housing parts 24a, 24b, and an opening 26 permits passage of cables into the recess 18. A cover 27 (see FIGS. 1A and 2A) may partially cover the opening 26. The cover 27 includes holes 28 for the cables to pass through. The cover 27 may form a part of the cable clamp 19 shown in FIG. 6.

As shown in FIG. 10, the clip members 15 may be formed on the second housing part 24b. Also, the spring retaining clips 5 may be attached to the second housing part 24b.

In this way, the fitting 2 can be assembled by positioning the power supply unit in the recess 18 of the second housing part 24b and then attaching the first and second housing parts 24a, 24b to each other.

The building control sensor system 1 described above may be provided as a kit. The kit may include the fitting 2 with mounting holes 4 and spring retaining clips 5, the building control sensor 3, and the sleeve 14. With this kit the installer can either hole-mount the fitting 2 using the spring retaining clips 5, or surface-mount the fitting 2 by removing the spring retaining clips 5 and using the mounting holes 4 and sleeve 14. In other examples, the fitting 2 and sleeve 14 may be provided to the installer as a kit that is compatible with a number of different building control sensors 3, thereby allowing a single fitting 2 to be stocked and transported for use with various building control sensors 3.

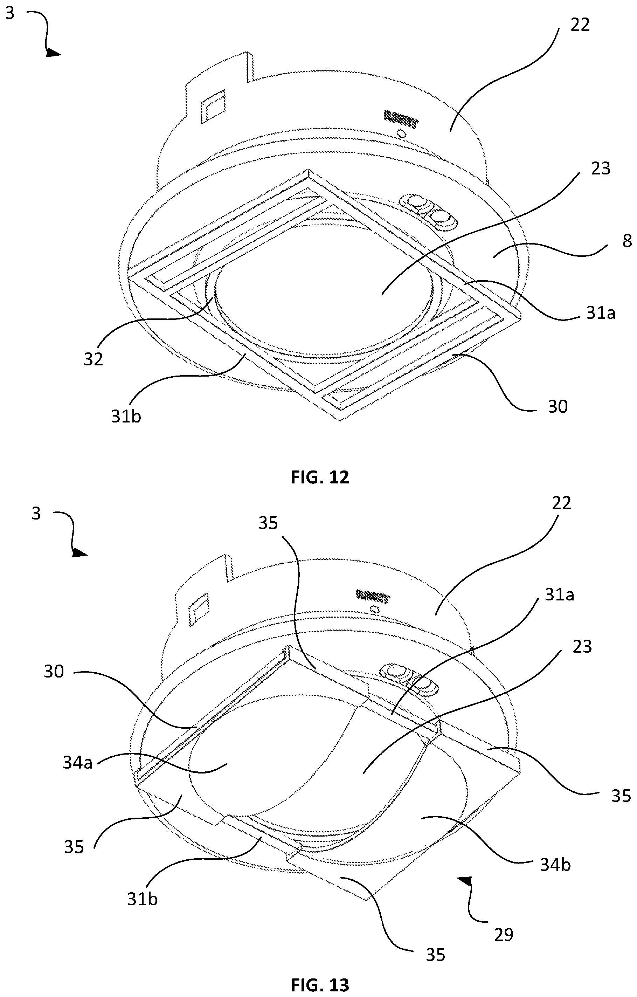

FIGS. 12 to 14 illustrate an additional feature of the building control sensor system 1 described above. In particular, FIGS. 12 to 14 illustrate a shield attachment 29 for the building control sensor 3. The shield attachment 29 has a frame 30 that can be attached to the building control sensor 3, around the lens 23. The shield attachment 29 further has a moveable shield element 34 that attaches to the frame 30 and can move along the frame 30. Movement of the shield element 31 changes a field of view of the building control sensor 3 as described further hereinafter.

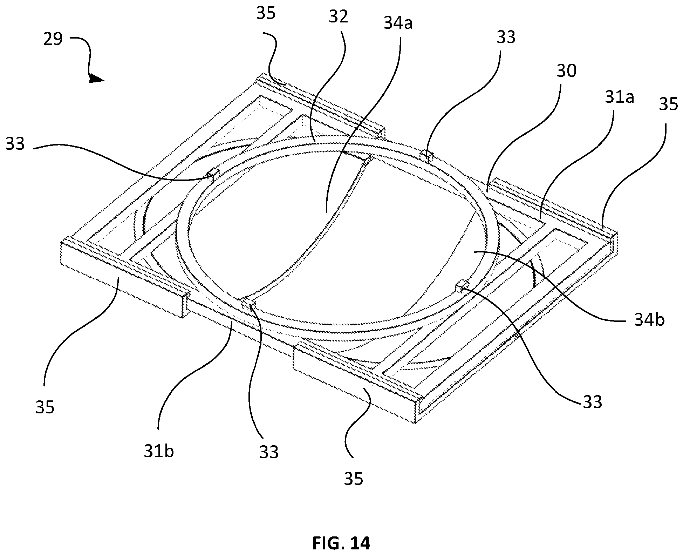

As shown in FIGS. 12 and 14, the frame 30 of the shield attachment 29 is quadrangular and has parallel rails 31a, 31b that, when attached to the building control sensor 3, are positioned on opposite sides of the lens 23. The frame 30 also includes a mounting portion 32 that includes clips 33 for attachment to corresponding clip holes on the building control sensor 3, about the lens 23. In this way, the frame 30 can be attached to the building control sensor 3 such that the rails 31a, 31b extend along opposite sides of the lens 23 as shown in FIG. 12. As shown, the frame 30 comprises four clips 33 equally spaced about the mounting portion 32. Accordingly, the frame 30 can be attached to the building control sensor in a number of orientations. Further, intermediate, clips 33 may be provided to increase the number of potential mounting orientations. In some examples, the clips 33 on the frame 30 may engage a circular groove or lip on the building control sensor 3, for example an edge of the lens 23, such that the shield attachment 29 can be freely rotated relative to the lens 23.

As shown in FIGS. 13 and 14, two shield elements 34a, 34b are attachable to the frame 30, in particular the rails 31a, 31b. The shield elements 34a, 34b comprise sliding portions 35 that partially wrap-around the rails 31a, 31b and allow the shield elements 34a, 34b to slide along the rails 31a, 31b. The sliding portions 35 may be a friction fit on the rails 31a, 31b so that the shield elements 34a, 34b are securely held in place but able to be moved by application of force by an installer. Alternatively, a lock may be provided, for example a grub screw or similar fastener for locking the position of the shield elements 34a, 34b on the frame 30.

The shield elements 34a, 34b also comprise a moulded portion that substantially matches the shape of the lens 23. In this way, the shield elements 34a, 34b can be moved, independently, to each partially cover the lens 23 and change a field of view of the lens 23.

The shield attachment 29 provides a simple and effective way of changing the field of view of the building control sensor 3. In particular, the shield members 34a, 34b can be independently slid along the rails 31a, 31b to change a separation between the shield members 34a, 34b and change the part of the lens 23 that is exposed. In addition, the shield attachment 29 can be detached from the building control sensor 3 and reattached in a different orientation (or rotated relative to the building control sensor 3), thereby changing the sliding direction of the shield members 34a, 34b and the field of view. Accordingly, the field of view can be adjusted based on where the building control sensor 3 is mounted and other requirements of the installation. For example, the shield members 34a, 34b can be positioned relatively close to each other to limit the field of view to a corridor or other limited space, or if the building control sensor is in a high bay mounting position (i.e., mounted high relative to the floor). In other examples, the shield members 34a, 34b can be moved apart to increase the field of view of the building control sensor 3, for example for mounting on a regular height ceiling or where a wide field of view is otherwise desirable.

The clips 33 allow the shield attachment 29 to be easily attached and detached as needed. Not all installations will require the shield attachment 29, so because of the clips 33 it can be omitted when not required.

As explained with reference to FIGS. 1 to 11, the building control sensor system 1 described herein can be mounted in either a hole-mounted configuration using the spring retaining clips 5 (see FIGS. 1A and 1B), or in a surface-mounted configuration by removing the spring retaining clips (see FIGS. 2A and 2B). Accordingly, only one type of fitting 2 needs to be manufactured, stocked, and supplied for hole mounting and surface mounting, and the installer can make the necessary configuration on site. In addition, the shield attachment 29 described with reference to FIGS. 12 to 14 provides additionally configurability, as the shield attachment 9 can be adjusted based on the specific installation site and without the need for specific components or cutting/breaking components. The shield attachment 29 can also be adjusted or removed if the installation site requirements change.

In the various examples described above the building control sensor 3 is a lighting control sensor, for example to detect movement, motion, presence, absence, and/or occupancy. The sensors may include a passive infrared (PIR) sensor. In other examples, the lighting control sensor may be a light level sensor adapted to detect an environment light level. In other examples the lighting control sensor may detect other environment characteristics for controlling lighting.

In other examples, the building control sensor 3 may comprise a fire alarm sensor, for example a smoke or heat detector. In other examples, the building control sensor 3 may comprise a gas sensor, for example a carbon monoxide sensor or sensor for other gases, particularly noxious gases.

Accordingly, the fitting 2 described with reference to FIGS. 1 to 11 may be used to mount any building control sensor to a surface, for example a ceiling or a wall.

Throughout this specification, the words "comprise" and "contain" and variations of them mean "including but not limited to", and they are not intended to (and do not) exclude other components, integers or steps. Throughout this specification, the singular encompasses the plural unless the context otherwise requires. In particular, where the indefinite article is used, the specification is to be understood as contemplating plurality as well as singularity, unless the context requires otherwise. Throughout this specification, the term "about" is used to provide flexibility to a range endpoint by providing that a given value may be "a little above" or "a little below" the endpoint. The degree of flexibility of this term can be dictated by the particular variable and can be determined based on experience and the associated description herein.

Features, integers or characteristics described in conjunction with a particular aspect or example of the invention are to be understood to be applicable to any other aspect or example described herein unless incompatible therewith. All of the features disclosed in this specification, and/or all of the steps of any method or process so disclosed, may be combined in any combination, except combinations where at least some of such features and/or steps are mutually exclusive. The invention is not restricted to the details of any foregoing examples. It will be also be appreciated that, throughout this specification, language in the general form of "X for Y" (where Y is some action, activity or step and X is some means for carrying out that action, activity or step) encompasses means X adapted or arranged specifically, but not exclusively, to do Y.

Each feature disclosed in this specification may be replaced by alternative features serving the ame or similar purpose, unless expressly stated otherwise. Thus, unless expressly stated otherwise, each feature disclosed is one example only of a generic series of similar features.

## Claims

1. A fitting (2) for mounting a building control sensor (3) to a surface, the fitting (2) comprising:
a mounting hole (4) for screwing the fitting (2) to the surface, and,
a spring retaining clip (5) adapted to retain the fitting (2) within a hole formed in the surface, comprising a torsion spring portion (6) having two parts (6a, 6b) that are spaced apart, and an arm (7) extending from the torsion spring portion (6); and
a mounting recess (9) for the spring retaining clip (5), **characterized in** comprising two spigots (10a, 10b) that are parallel to each other, spaced apart and extend towards each other, each of the two spigots (10a, 10b) configured to engage, respectively, the first and second parts (6a, 6b) of the torsion spring portion (6),
wherein the mounting hole (4) extends from the mounting recess (9) and the spigots (10a, 10b) are arranged proximal to the mounting hole (4) in the mounting recess (9) and wherein the spring retaining clip (5) is removeable,
such that the fitting (2) can be configured for surface-mounting using the mounting hole or for hole-mounting using the spring retaining clip (5).

2. **The** fitting (2) of claim 1, wherein the spring retaining clip (5) is mounted in the mounting recess (9) of the fitting (2).

3. **The** fitting (2) of any preceding claim, wherein the fitting (2) comprising a planar face (17) arranged to abut the surface when using the mounting hole (4), and wherein the mounting hole (4) is perpendicular to the planar face (17).

4. **The** fitting (2) of any preceding claim, comprising first and second mounting holes (4) and first and second spring retaining clips (5).

5. **The** fitting (2) of any preceding claim, further comprising a power supply unit.

6. **The** fitting (2) of claim 5, further comprising a removable cover for covering the power supply unit.

7. **The** fitting (2) of any preceding claim, further comprising a clip for attaching the building control sensor (3) to the fitting (2).

8. The fitting (2) of claim 7, wherein the clip comprises a resiliently deflectable prong protruding from the fitting (2) and arranged to engage a clip hole of the building control sensor (3).

9. The fitting (2) of claim 7 or claim 8, further comprising a connector arranged to provide an electrical connection between the fitting (2), in particular the power supply unit, and the building control sensor (3) when the building control sensor (3) is attached to the fitting (2).

10. The fitting (2) of any of claims 7 to 9, wherein the fitting (2) comprises a first housing portion and a second housing portion.

11. A building control sensor system comprising of the fitting (2) of any preceding claim and a building control sensor (3) attachable to the fitting (2).

12. The building control sensor system of claim 11, wherein the building control sensor (3) is a lighting control sensor or a fire alarm.

## Patentansprüche

1. Armatur (2) zur Montage eines Gebäudesteuerungssensors (3) an einer Oberfläche, wobei die Armatur (2) Folgendes umfasst:
ein Montageloch (4) zum Schrauben der Armatur (2) an die Oberfläche, und
eine Federhalteklammer (5), die dazu ausgelegt ist, die Armatur (2) innerhalb eines Lochs zu halten, das in der Oberfläche gebildet ist, umfassend einen Torsionsfederabschnitt (6) mit zwei Teilen (6a, 6b), die beabstandet sind, und einen Arm (7), der sich von dem Torsionsfederabschnitt (6) erstreckt; und
eine Montageausnehmung (9) für die Federhalteklammer (5),
**dadurch gekennzeichnet, dass** sie zwei Zapfen (10a, 10b) umfasst, die parallel zueinander sind, voneinander beabstandet sind und sich zueinander erstrecken, wobei jeder der zwei Zapfen (10a, 10b) dazu konfiguriert ist, jeweils den ersten und den zweiten Teil (6a, 6b) des Torsionsfederabschnittes (6) in Eingriff zu nehmen,
wobei sich das Montageloch (4) von der Montageausnehmung (9) erstreckt und die Zapfen (10a, 10b) proximal zu dem Montageloch (4) in der Montageausnehmung (9) angeordnet sind und wobei die Federhalteklammer (5) entfernbar ist,
sodass die Armatur (2) für Oberflächenmontage unter Verwendung des Montagelochs oder für Lochmontage unter Verwendung der Federhalteklammer (5) konfiguriert sein kann.

2. Armatur (2) nach Anspruch 1, wobei die Federhalteklammer (5) in der Montageausnehmung (9) der Armatur (2) montiert ist.

3. Armatur (2) nach einem vorhergehenden Anspruch, wobei die Armatur (2) eine ebene Fläche (17) umfasst, die dazu angeordnet ist, an der Oberfläche anzuliegen, wenn das Montageloch (4) verwendet wird, und wobei das Montageloch (4) senkrecht zu der ebenen Fläche (17) ist.

4. Armatur (2) nach einem vorhergehenden Anspruch, umfassend ein erstes und ein zweites Montageloch (4) und eine erste und eine zweite Federhalteklammer (5).

5. Armatur (2) nach einem vorhergehenden Anspruch, ferner umfassend eine Leistungsversorgungseinheit.

6. Armatur (2) nach Anspruch 5, ferner umfassend eine entfernbare Abdeckung zum Abdecken der Leistungsversorgungseinheit.

7. Armatur (2) nach einem vorhergehenden Anspruch, ferner umfassend eine Klammer zum Anbringen des Gebäudesteuerungssensors (3) an der Armatur (2).

8. Armatur (2) nach Anspruch 7, wobei die Klammer einen elastisch ablenkbaren Zinken umfasst, der von der Armatur (2) vorsteht und dazu angeordnet ist, ein Klammerloch des Gebäudesteuerungssensors (3) in Eingriff zu nehmen.

9. Armatur (2) nach Anspruch 7 oder Anspruch 8, ferner umfassend einen Verbinder, der dazu angeordnet ist, eine elektrische Verbindung zwischen der Armatur (2), insbesondere der Leistungsversorgungseinheit, und dem Gebäudesteuerungssensor (3) bereitzustellen, wenn der Gebäudesteuerungssensor (3) an der Armatur (2) angebracht ist.

10. Armatur (2) nach einem der Ansprüche 7 bis 9, wobei die Armatur (2) einen ersten Gehäuseabschnitt und einen zweiten Gehäuseabschnitt umfasst.

11. Gebäudesteuerungssensorsystem, umfassend die Armatur (2) nach einem vorhergehenden Anspruch und einen Gebäudesteuerungssensor (3), der an der Armatur (2) anbringbar ist.

12. Gebäudesteuerungssensorsystem nach Anspruch 11, wobei der Gebäudesteuerungssensor (3) ein Beleuchtungssteuerungssensor oder ein Feueralarm ist.

## Revendications

1. Support (2) pour le montage d'un capteur de commande de bâtiment (3) sur une surface, le support (2) comprenant :
un trou de montage (4) pour visser le support (2) à la surface, et
une pince de retenue de ressort (5) conçue pour retenir le support (2) à l'intérieur d'un trou formé dans la surface, comprenant une partie ressort de torsion (6) comportant deux pièces (6a, 6b) qui sont espacées, et un bras (7) s'étendant à partir de la partie ressort de torsion (6) ; et
un évidement de montage (9) pour la pince de retenue de ressort (5), le support étant **caractérisé en ce qu'**il comprend deux ergots (10a, 10b) qui sont parallèles l'un à l'autre, espacés et s'étendent l'un vers l'autre, chacun des deux ergots (10a, 10b) étant configuré pour s'engager, respectivement, dans les première et seconde pièces (6a, 6b) de la partie ressort de torsion (6),
ledit trou de montage (4) s'étendant à partir de l'évidement de montage (9) et lesdits ergots (10a, 10b) étant agencés à proximité du trou de montage (4) dans l'évidement de montage (9), et ladite pince de retenue de ressort (5) étant amovible,
de sorte que le support (2) puisse être configuré pour un montage en surface au moyen du trou de montage ou pour un montage en trou au moyen de la pince de retenue de ressort (5).

2. Support (2) selon la revendication 1, ladite pince de retenue de ressort (5) étant montée dans l'évidement de montage (9) du support (2).

3. Support (2) selon l'une quelconque des revendications précédentes, ledit support (2) comprenant une face plane (17) agencée pour buter contre la surface lors de l'utilisation du trou de montage (4), et ledit trou de montage (4) étant perpendiculaire à la face plane (17).

4. Support (2) selon l'une quelconque des revendications précédentes, comprenant des premier et second trous de montage (4) et des première et seconde pinces de retenue de ressort (5).

5. Support (2) selon l'une quelconque des revendications précédentes, comprenant en outre une unité d'alimentation électrique.

6. Support (2) selon la revendication 5, comprenant en outre un couvercle amovible pour couvrir l'unité d'alimentation électrique.

7. Support (2) selon l'une quelconque des revendications précédentes, comprenant en outre une pince pour fixer le capteur de commande de bâtiment (3) au support (2).

8. Support (2) selon la revendication 7, ladite pince comprenant une dent pouvant être fléchie de manière élastique faisant saillie du support (2) et agencée pour s'engager dans un trou de pince du capteur de commande de bâtiment (3).

9. Support (2) selon la revendication 7 ou la revendication 8, comprenant en outre un connecteur agencé pour assurer une connexion électrique entre le support (2), en particulier l'unité d'alimentation électrique, et le capteur de commande de bâtiment (3) lorsque le capteur de commande de bâtiment (3) est fixé au support (2).

10. Support (2) selon l'une quelconque des revendications 7 à 9, ledit support (2) comprenant une première partie boîtier et une seconde partie boîtier.

11. Système de capteur de commande de bâtiment comprenant le support (2) selon l'une quelconque des revendications précédentes et un capteur de commande de bâtiment (3) pouvant être fixé au support (2).

12. Système de capteur de commande de bâtiment selon la revendication 11, ledit capteur de commande de bâtiment (3) étant un capteur de commande d'éclairage ou une alarme incendie.
